# EUROPEAN PATENT APPLICATION

(11) **EP 3 506 494 A1**
(43) Date of publication of application: **03.07.2019**
(21) Application number: 18185535.4
(22) Date of filing: 25.07.2018
(51) Int. Cl.: H02S 50/10, H02S 50/15

(54) **METHOD AND SYSTEM FOR TESTING MECHANICAL TOLERANCE OF PHOTOVOLTAIC MODULE**

(30) Priority: 26.12.2017 CN 201711440814
(71) Applicant: Miasole Photovoltaic Technology Co., Ltd., Beijing (CN)
(72) Inventor: SUN, Junbo, BEIJING (CN); YANG, Sheng, BEIJING (CN); AO, Huaming, BEIJING (CN)
(74) Representative: Cabinet Beau de Loménie

(57) **Abstract**

The present disclosure relates to a method and system for testing mechanical tolerance of a photovoltaic module. The method include sequential steps of: according to a predetermined appearance inspection standard, performing an appearance defect inspection on the photovoltaic module; testing a light attenuation rate of the photovoltaic module, and when the light attenuation rate is smaller than a predetermined attenuation threshold, under a predetermined test condition, checking an output power of the photovoltaic module; performing a mechanical tolerance test on the photovoltaic module; according to the appearance inspection standard, performing an appearance defect inspection on the photovoltaic module; checking the output power of the photovoltaic module under the predetermined test condition; and ending testing of the mechanical tolerance.

## Description

### TECHNICAL FIELD

The present disclosure relates to the photovoltaic power supply technology for shared bikes, and in particular, to a method and system for testing mechanical tolerance of a photovoltaic module.

### BACKGROUND

Shared bike is a product of sharing economies that have emerged in recent years. Because of the advantages such as convenience, environment friendliness, and low prices, shared bikes have quickly won the favor of consumers. At the same time, shared bikes have driven the rapid development of the mobile energy industry.

Photovoltaic modules for the shared bikes are integrated into bodies of the shared bikes (usually placed in a basket), and the bike batteries of the shared bikes are charged through sunlight to meet the power demands of various types of electrical equipment, for example, "smart locks" of the shared bikes, thereby improving the efficiency in energy production, recycling, and sharing for shared bikes.

However, at present, there are no test and analysis methods and standards for testing the performance and lifetime of photovoltaic modules used in the shared bikes, for example, there are no testing processes and determination standards of the mechanical tolerance of the photovoltaic modules used in the shared bikes.

### SUMMARY

An objective of the present disclosure is, aiming at the capability for withstanding external stress of photovoltaic modules used on shared bikes, to provide a method and system for testing mechanical tolerance of a photovoltaic module, so as to make up for the absence of a method for testing photovoltaic modules used on the shared bikes.

The technical solutions of the present disclosure are as follows.

There is provided a method for testing mechanical tolerance of a photovoltaic module, including sequential steps of:
step S1, according to a predetermined appearance inspection standard, performing an appearance defect inspection on the photovoltaic module;
step S2, testing a light attenuation rate of the photovoltaic module, and when the light attenuation rate is smaller than a predetermined attenuation threshold, performing step S3;
step S3, under a predetermined test condition, checking an output power of the photovoltaic module;
step S4, performing a mechanical tolerance test on the photovoltaic module;
step S5, according to the appearance inspection standard, performing an appearance defect inspection on the photovoltaic module;
step S6, checking the output power of the photovoltaic module under the predetermined test condition; and
step S7, ending testing of the mechanical tolerance.

The mechanical tolerance test may include any one or a combination of a drop tolerance test, a vibration tolerance test, or an impact tolerance test.

The drop tolerance test may include:
making the flat-laid photovoltaic module to freely drop from a predetermined first height for a predetermined number of times.

The vibration tolerance test may include:
placing a vibration test component on the photovoltaic module, and
driving the photovoltaic module to vibrate at a predetermined amplitude for a predetermined time to make the vibration test component and the photovoltaic module move relatively.

The impact tolerance test may include:
making an impact test component to freely fall from a predetermined second height to a surface of the photovoltaic module for a predetermined number of times.

After checking the output power of the photovoltaic module, the method may further include:
performing an internal structure inspection on the photovoltaic module.

The testing the light attenuation rate of the photovoltaic module may include:
simulating solar radiation, and irradiating the photovoltaic module according to a predetermined radiation energy and a predetermined number of times.

There is further provided a system for testing mechanical tolerance of a photovoltaic module, including a module appearance inspection device, a light attenuation rate test device, a power check device, a mechanical tolerance test platform, a controller and a carrier unit;
wherein:
the module appearance inspection device is configured to perform an appearance defect inspection on the photovoltaic module;
the light attenuation rate test device is configured to test a light attenuation rate of the photovoltaic module;
the power check device is configured to check an output power of the photovoltaic module;
the mechanical tolerance test platform is configured to perform a mechanical tolerance test on the photovoltaic module;
the controller is configured to control the carrier unit to carry the photovoltaic module to respective one of the above devices and platform according to the sequence of the steps in the method for testing mechanical tolerance of the photovoltaic module.

The system for testing mechanical tolerance may further include an infrared imaging device configured to perform an internal structure inspection on the photovoltaic module.

The light attenuation rate test device may include a light absorption test chamber.

In the exemplary embodiments of the present disclosure, for the photovoltaic modules used on the shared bikes, simulation experiments (or tests) based on capability for undergoing external stress actually are performed, and according to a particular test sequence, the performance of the photovoltaic modules before and after the experiments are tested in order. Embodiments of the present disclosure can provide reliable analysis basis and determination criteria for usage performance, lifetime and expiry period of the photovoltaic modules under different application situations. Meanwhile, the embodiments of the present disclosure also provide support for analysis data for technology upgrading in this industry. The present disclosure can not only make up for the absence of the testing procedure for the photovoltaic modules used on shared bikes, but also can provide forceful technical guarantee for users of the shared bikes.

### BRIEF DESCRIPTION OF THE DRAWINGS

Objectives, technical solutions, and advantages of the present disclosure will become apparent from the following description of the present disclosure with reference to drawings, in which:
Fig. 1 is a flow chart of a method for testing mechanical tolerance of a photovoltaic module according to an embodiment of the present disclosure.
Fig. 2 is a flow chart of another method for testing mechanical tolerance of a photovoltaic module according to an embodiment of the present disclosure.

### DETAILED DESCRIPTION

Embodiments of the present disclosure are described in detail below, and exemplary embodiments are shown in the accompanying drawings, in which the same or similar reference numbers denote the same or similar elements or elements having the same or similar functions throughout. The embodiments described below with reference to the drawings are exemplary, are used to explain the present disclosure only, and cannot be construed as limiting the present disclosure.

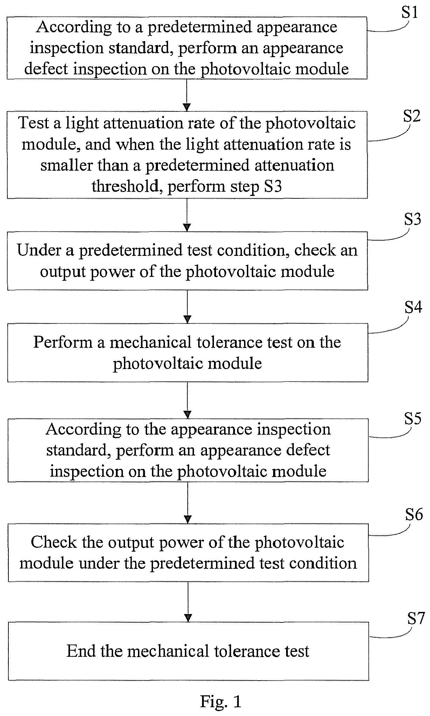

An embodiment of the present disclosure provides a method for testing mechanical tolerance of a photovoltaic module. As shown in Fig. 1, the method includes the following steps in sequence.

In step S1, according to a predetermined appearance inspection standard, an appearance defect inspection is performed on the photovoltaic module.

First of all, before the mechanical tolerance test, the module to be tested is visually inspected. The basis of the inspection criteria may be an appearance inspection specification customized for the photovoltaic products for shared bikes. The purpose is to check whether the appearance of the photovoltaic module is obviously defective or there is any defect in the appearance of the photovoltaic module which goes beyond the appearance inspection specification. The photovoltaic module used in the shared bikes described herein may include photovoltaic modules of types such as the crystalline silicon, thin film, and the like.

In step S2, a light attenuation rate of the photovoltaic module is tested, and when the light attenuation rate is smaller than a predetermined attenuation threshold, step S3 is performed.

Next, a light attenuation rate test of the photovoltaic module is performed. Since this step is before the mechanical tolerance test, those skilled in the art may understand that this step is an initial light attenuation rate test which is performed to determine whether the photovoltaic module product meets the reliability as required in the shared bike application field. Thus, the attenuation threshold may be set to be a relatively small value, for example, 1%. That is, the subsequent steps may be performed only if the light attenuation rate is smaller than 1%. The so-called light attenuation refers to that the output power of the photovoltaic module experiences a significant decrease during the first few days of the first use. In actual operations, the light attenuation may be reduced by replacing the boron element with the gallium element, or pre-illumination may be performed on the photovoltaic module to control the initial light attenuation of the photovoltaic module within a relatively small range, thereby increasing the output stability of the photovoltaic module. Therefore, in an exemplary embodiment of the present disclosure, when performing the light attenuation rate test on the photovoltaic module, solar radiation may be simulated, and the photovoltaic module is continuously irradiated according to predetermined radiation energy and a predetermined number of times. The predetermined radiation energy may be 20Kwh, and the predetermined number of times may be at least twice.

In step S3, under a predetermined test condition, an output power of the photovoltaic module is checked.

For a photovoltaic module that meets the output stability as required for a shared bike, the output power check is a double-check method proposed by the present disclosure. Here, the predetermined test condition refers to a power check according to any of the established standards, such as national standards, international standards or industrial standards. For example, the check of the output power may be performed by referring to the STC test standard. The reason for the double-check is as follows: after the aforementioned light attenuation step, the output power of the photovoltaic module may be abnormal due to placing or carrying of the photovoltaic module and the like, and in order to ensure the overall state of the photovoltaic module before entering the subsequent mechanical tolerance test, the double-check is performed. It should be noted that, in another exemplary embodiment of the present disclosure, after checking the output power of the photovoltaic module, an internal structure inspection may be performed on the photovoltaic module to sufficiently ensure the state of the photovoltaic module before the test. Further, this may provide a contrast reference for the status data of the module after the test.

In step S4, a mechanical tolerance test is performed on the photovoltaic module.

After the aforementioned tests (or detections), the mechanical tolerance test is performed according to a specific capability of the shared bike for withstanding an external stress actually, i.e., extreme or bad mechanical and physical damage and interference that may occur. Since the situations in which the shared bikes are used in practice are relatively complex and diverse, the mechanical tolerance test described here may also be diversified. The present disclosure provides the following three tests as examples: a drop tolerance test, a vibration tolerance test, and an impact tolerance test. When the mechanical tolerance test is performed, any one of the plurality of tests may be selected or a combination of the plurality of tests may be used according to actual requirements.

Specifically, the drop tolerance test refers to allowing the flat-laid photovoltaic module to freely fall from a predetermined first height for a predetermined number of times, for example, allowing the flat-laid photovoltaic module to freely fall from a height of 2 meters for 20 times. This condition is used to simulate the specific drop conditions of the photovoltaic modules used for shared bikes, such as the situations when the shared bikes fall down, or the shared bikes drop due to irregular loading and unloading operations. The vibration tolerance test refers to placing a vibration test component on the photovoltaic module, and driving the photovoltaic module to vibrate at a predetermined amplitude for a predetermined time to make the vibration test component and the photovoltaic module move relatively. In actual operations, the photovoltaic module may be fixed in the basket of a shared bike, and multiple free-moving steel cylinders are placed in the basket, and then the basket (photovoltaic module) is driven to continuously vibrate at an amplitude of 25mm for 3 hours. This condition is used to simulate the vibration of the photovoltaic module itself and the relative vibration of the photovoltaic module generated by an item placed on the photovoltaic module during driving the shared bike that uses the photovoltaic module on a bumpy road. It should be pointed out that the material, size, shape, quantity, and weight of the vibration test component may be adjusted according to actual usage conditions, and the amplitude and time may also be set flexibly. The impact tolerance test refers to allowing an impact test component to freely fall from a predetermined second height to a surface of the photovoltaic module for a predetermined number of times. In actual operation, a certain weight (for example, bottled water of 500g) may be freely dropped from the height of 1 meter to the surface of the photovoltaic module, and the test is repeated for 20 times. This condition is used to simulate the impact on the photovoltaic module when the user uses the shared bike to throw an item into the basket. Those skilled in the art may understand that the aforementioned parameters such as times, heights, and weights may be adjusted based on actual conditions.

In step S5, according to the appearance inspection standard, an appearance defect inspection is performed on the photovoltaic module.

After the above mechanical tolerance test is finished, appearance defect inspection needs to be performed on the photovoltaic module again. The appearance inspection standard may be the same as that before the test, for example, a product appearance inspection specification. The purpose for this inspection is to re-examine whether the mechanical tolerance test imposes an influence (e.g., defects which are not in comply with the specification due to drop, impact or vibration) on the appearance of the photovoltaic module.

In step S6, the output power of the photovoltaic module is checked under the predetermined test condition.

After the appearance inspection, the output power of the photovoltaic module is checked again, so as to determine the influences of different bad mechanical usage situations on the electrical properties of the photovoltaic module. Descriptions regarding the test standards may be found in the steps before the test and repeated descriptions are omitted. In the mechanical tolerance test, there is no aging problem caused by climate and time factors, so there is no need to recheck light attenuation. However, for the mechanical tolerance test, it is possible to consider performing an internal structure inspection again. It should be further pointed out that in actual operations, if the check of the output power is not used, the internal structure inspection on the photovoltaic module may also be implemented. That is, if steps S3 and S6 are not performed, the internal structure inspection may be performed before and after the mechanical tolerance test, and there is no necessary relationship between the internal structure inspection and the check of the output power.

In step S7, till now, the testing of the mechanical tolerance for the photovoltaic module used in the shared bike is ended.

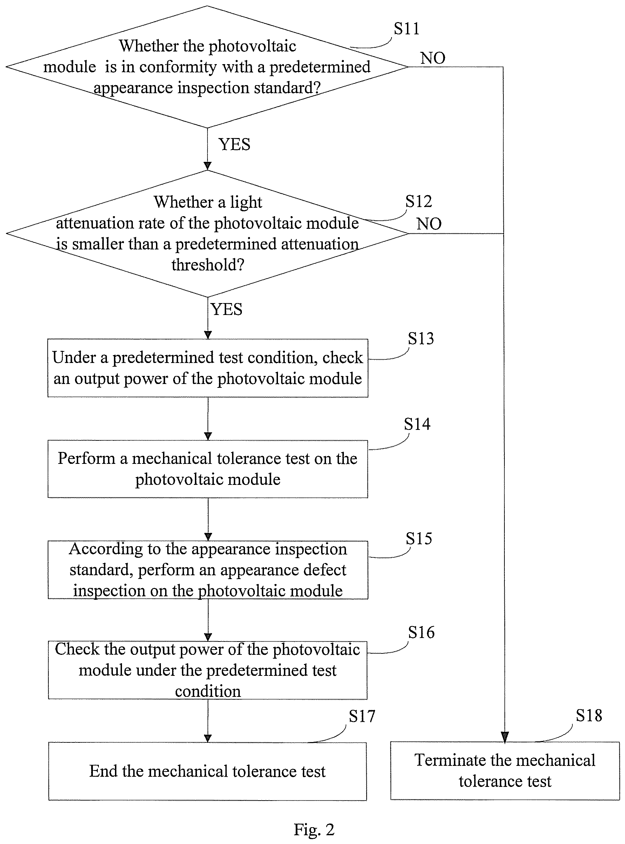

Another embodiment of the present disclosure further provides a method for testing mechanical tolerance of a photovoltaic module. As shown in Fig. 2, the method includes the following steps in sequence.

In step S11, whether the photovoltaic module is in conformity with a predetermined appearance inspection standard is detected (or determined).

First of all, before the mechanical tolerance test, the module to be tested is visually inspected. The basis of the inspection criteria may be an appearance inspection specification customized for the photovoltaic products for shared bikes. The purpose is to check whether the appearance of the photovoltaic module is obviously defective or there is any defect in the appearance of the photovoltaic module which goes beyond the appearance inspection specification. The photovoltaic module used in the shared bikes described herein may include photovoltaic modules of types such as the crystalline silicon, thin film, and the like.

If it is detected in step S11 that the photovoltaic module is not in conformity with the predetermined appearance inspection standard, the flow proceeds to step S18, and the mechanical tolerance test is terminated, i.e., the mechanical tolerance test is not continued, and the photovoltaic module may be determined as unqualified or nonconforming. If it is detected in step S11 that the photovoltaic module is in conformity with the predetermined appearance inspection standard, the flow proceeds to step S12.

In step S12, whether a light attenuation rate of the photovoltaic module is smaller than a predetermined attenuation threshold is determined..

In step S12, a light attenuation rate test of the photovoltaic module is performed. Since this step is before the mechanical tolerance test, those skilled in the art may understand that this step is an initial light attenuation rate test which is performed to determine whether the photovoltaic module product meets the reliability as required in the shared bike application field. Thus, the attenuation threshold may be set to be a relatively small value, for example 1%. That is, the subsequent steps may be performed only if the light attenuation rate is smaller than 1%. The so-called light attenuation refers to that the output power of the photovoltaic module experiences a significant decrease during the first few days of the first use. In actual operations, the light attenuation may be reduced by replacing the boron element with the gallium element, or pre-lighting may be performed on the photovoltaic module to control the initial light attenuation of the photovoltaic module within a relatively small range, thereby increasing the output stability of the photovoltaic module. Therefore, in an exemplary embodiment of the present disclosure, when performing the light attenuation rate test on the photovoltaic module, solar radiation may be simulated, and the photovoltaic module is continuously irradiated according to a predetermined radiation energy and a predetermined number of times. The predetermined radiation energy may be 20Kwh, and the predetermined number of times may be at least twice.

If it is detected in step S12 that the light attenuation rate of the photovoltaic module is not smaller than the predetermined attenuation threshold, the flow proceeds to step S18, the mechanical tolerance test is terminated, i.e., the mechanical tolerance test is not continued, and the photovoltaic module may be determined as unqualified or nonconforming. If it is detected in step S12 that the light attenuation rate of the photovoltaic module is smaller than the predetermined attenuation threshold, the flow proceeds to step S13.

In step S13, under a predetermined test condition, an output power of the photovoltaic module is checked.

For a photovoltaic module that meets the output stability as required for a shared bike, the output power check is a double-check method proposed by the present disclosure. Here, the predetermined test condition refers to a power check according to any of the established standards, such as national standards, international standards or industrial standards. For example, the check of the output power may be performed by referring to the STC test standard. The reason for the double-check is as follows: after the aforementioned light attenuation step, the output power of the photovoltaic module may be abnormal due to placing or carrying of the photovoltaic module and the like, and in order to ensure the overall state of the photovoltaic module before entering the subsequent mechanical tolerance test, the double-check is performed. It should be noted that, in another exemplary embodiment of the present disclosure, after checking the output power of the photovoltaic module, an internal structure inspection may be performed on the photovoltaic module to sufficiently ensure the state of the photovoltaic module before the test. Further, this may provide a contrast reference for the status data of the module after the test.

In step S14, a mechanical tolerance test is performed on the photovoltaic module.

After the aforementioned tests (or detections), the mechanical tolerance test is performed according to a specific capability of the shared bike for withstanding an external stress actually, i.e., extreme or bad mechanical and physical damage and interference that may occur. Since the situations in which the shared bikes are used in practice are relatively complex and diverse, the mechanical tolerance test described here may also be diversified. The present disclosure provides the following three tests as examples: a drop tolerance test, a vibration tolerance test, and an impact tolerance test. When the mechanical tolerance test is performed, any one of the plurality of tests may be selected or a combination of the plurality of tests may be used according to actual requirements.

Specifically, the drop tolerance test refers to allowing the flat-laid photovoltaic module to freely fall from a predetermined first height for a predetermined number of times, for example, allowing the flat-laid photovoltaic module to freely fall from a height of 2 meters for 20 times. This condition is used to simulate the specific drop conditions of the photovoltaic modules used for shared bikes, such as the situations when the shared bikes fall down, or the shared bikes drop due to irregular loading and unloading operations. The vibration tolerance test refers to placing a vibration test component on the photovoltaic module, and driving the photovoltaic module to vibrate at a predetermined amplitude for a predetermined time to make the vibration test component and the photovoltaic module move relatively. In actual operations, the photovoltaic module may be fixed in the basket of a shared bike, and multiple free-moving steel cylinders are placed in the basket, and then the basket (photovoltaic module) is driven to continuously vibrate at an amplitude of 25mm for 3 hours. This condition is used to simulate the vibration of the photovoltaic module itself and the relative vibration of the photovoltaic module generated by an item placed on the photovoltaic module during driving the shared bike that uses the photovoltaic module on a bumpy road. It should be pointed out that the material, size, shape, quantity, and weight of the vibration test component maybe adjusted according to actual usage conditions, and the amplitude and time may also be set flexibly. The impact tolerance test refers to allowing an impact test component to freely fall from a predetermined second height to a surface of the photovoltaic module for a predetermined number of times. In actual operation, a certain weight (for example, bottled water of 500g) may be freely dropped from the height of 1 meter to the surface of the photovoltaic module, and the test is repeated for 20 times. This condition is used to simulate the impact on the photovoltaic module when the user uses the shared bike to throw an item into the basket. Those skilled in the art may understand that the aforementioned parameters such as times, heights, and weights may be adjusted based on actual conditions.

In step S15, according to the appearance inspection standard, an appearance defect inspection is performed on the photovoltaic module.

After the above mechanical tolerance test is finished, appearance defect inspection needs to be performed on the photovoltaic module again. The appearance inspection standard may be the same as that before the test, for example, a product appearance inspection specification. The purpose for this inspection is to re-examine whether the mechanical tolerance test imposes an influence (e.g., defects which are not in comply with the specification due to drop, impact or vibration) on the appearance of the photovoltaic module.

In step S16, the output power of the photovoltaic module is checked under the predetermined test condition.

After the appearance inspection, the output power of the photovoltaic module is checked again, so as to determine the influences of different bad mechanical usage situations on the electrical properties of the photovoltaic module. Descriptions regarding the test standards maybe found in the steps before the test and repeated descriptions are omitted. In the mechanical tolerance test, there is no aging problem caused by climate and time factors, so there is no need to recheck light attenuation. However, for the mechanical tolerance test, it is possible to consider performing an internal structure inspection again. It should be further pointed out that in actual operations, if the check of the output power is not used, the internal structure inspection on the photovoltaic module may also be implemented. That is, if steps S13 and S16 are not performed, the internal structure inspection may be performed before and after the mechanical tolerance test, and there is no necessary relationship between the internal structure inspection and the check of the output power.

In step S17, till now, the testing of the mechanical tolerance for the photovoltaic module used in the shared bike is ended. Further, changes in appearance and output power of the photovoltaic module before and after the mechanical tolerance test may be output so as to obtain the mechanical tolerance test results of the photovoltaic module, and then it is also possible to make targeted improvements to the photovoltaic module.

Based on the above test flow, the present disclosure also accordingly provides a system for testing mechanical tolerance of a photovoltaic module. The system includes: a module appearance inspection device configured to perform an appearance defect inspection on the photovoltaic module; a light attenuation rate test device configured to test a light attenuation rate of the photovoltaic module; a power check device configured to check an output power of the photovoltaic module; a mechanical tolerance test platform configured to perform a mechanical tolerance test on the photovoltaic module; and a controller and a carrier unit.

The function of the controller is to control the carrier unit to carry the photovoltaic module to individual one of the above devices and the platform according to the sequence of the steps in the method for testing mechanical tolerance of the photovoltaic module, so as to realize the procedure for testing mechanical tolerance of a photovoltaic module used in a shared bike.

In specific operations, the types of the above devices are diverse. For example, the module appearance inspection device may be an image acquisition and analysis system, the light attenuation rate test device using light radiation may include a light absorption test chamber (LS/LID test chamber), the power check device may be a power tester (IV tester), the mechanical tolerance test platform may include a vehicle transportation vibration simulation platform, the carrier unit may be a manipulator operating on a track or a carrier system consisting of a conveyor belt and an elevator support mechanism, and the controller may be a programmable controller, a processor, an industrial computer and the like.

It should be further pointed out that if the test process includes the internal structure inspection on the photovoltaic module, an infrared imaging device such as an IR/NIR analyzer may also be included in the system for testing mechanical tolerance. Likewise, the controller controls the carrier unit to carry the photovoltaic module to the infrared imaging device in accordance with the above test procedure.

The structures, features, and effects of the present disclosure are described above in detail with reference to embodiments as shown in drawings. However, the above descriptions only show exemplary embodiments of the present disclosure. It should be noted that the technical features in the above exemplary embodiments can be reasonably combined into a plurality of equivalent solutions by a person skilled in the art without departing from or changing the design ideas and technical effects of the present disclosure.

### Industrial Applicability

Shared bike is a successful product of the sharing economies. With advantages such as convenience, environment friendliness and low prices, the shared bike has quickly been accepted by the consumers.

The use of solar technology combined with shared bikes matches the economic and social values of bike-sharing services. On the one hand, the shared bikes are produced as an independent power generation entity to provide power guarantees for all kinds of power equipment on the shared bikes through solar energy, thereby improving the efficiency in energy production, recycling, and sharing for the shared bikes. On the other hand, the shared bikes also promotes the rapid development of the green energy industry, which in turn protects the environment while also stimulating the upgrading and development of related industrial chains.

However, the shared bikes using the solar technology are emerging industrial products. Currently, there is no corresponding failure analysis and related test procedures and standards for the photovoltaic modules used in the shared bikes.

Therefore, in order to test the influences of specific usage situations on the capability for withstanding external stress of the photovoltaic modules equipped on shared bikes, the present disclosure proposes a targeted method for testing mechanical tolerance of a photovoltaic module to compensate for the inadequacies of related arts. The present disclosure can provide a mechanical tolerance test idea for performance evaluation and outdoor usage of the photovoltaic module, which ultimately can improve the usage experience of users of shared bikes. Therefore, the present disclosure can timely support emerging economies and their industrial products.

## Claims

1. A method for testing mechanical tolerance of a photovoltaic module, comprising sequential steps of:
according to a predetermined appearance inspection standard, performing an appearance defect inspection on the photovoltaic module (S1);
testing a light attenuation rate of the photovoltaic module (S2), and when the light attenuation rate is smaller than a predetermined attenuation threshold, performing, under a predetermined test condition, checking an output power of the photovoltaic module (S3);
performing a mechanical tolerance test on the photovoltaic module (S4);
according to the appearance inspection standard, performing an appearance defect inspection on the photovoltaic module (S5);
checking the output power of the photovoltaic module under the predetermined test condition (S6); and
ending testing of the mechanical tolerance (S7).

2. The method according to claim 1, wherein the mechanical tolerance test comprises any one of or a combination of a drop tolerance test, a vibration tolerance test, and an impact tolerance test.

3. The method according to claim 2, wherein the drop tolerance test comprises: making the flat-laid photovoltaic module to freely drop from a predetermined first height for a predetermined number of times.

4. The method according to claim 2 or 3, wherein the vibration tolerance test comprises:
placing a vibration test component on the photovoltaic module; and
driving the photovoltaic module to vibrate at a predetermined amplitude for a predetermined time to make the vibration test component and the photovoltaic module move relatively.

5. The method according to anyone of claims 2 to 4, wherein the impact tolerance test comprises: making an impact test component to freely fall from a predetermined second height to a surface of the photovoltaic module for a predetermined number of times.

6. The method according to any one of claims 1 to 5, wherein after checking the output power of the photovoltaic module, the method further comprises:
performing an internal structure inspection on the photovoltaic module.

7. The method according to any one of claims 1 to 5, wherein the testing the light attenuation rate of the photovoltaic module comprises: simulating solar radiation, and irradiating the photovoltaic module according to predetermined radiation energy and a predetermined number of times.

8. A system for testing mechanical tolerance of a photovoltaic module, comprising: a module appearance inspection device, a light attenuation rate test device, a power check device, a mechanical tolerance test platform, a controller and a carrier unit;
wherein:
the module appearance inspection device is configured to perform an appearance defect inspection on the photovoltaic module;
the light attenuation rate test device is configured to test a light attenuation rate of the photovoltaic module;
the power check device is configured to check an output power of the photovoltaic module;
the mechanical tolerance test platform is configured to perform a mechanical tolerance test on the photovoltaic module; and
the controller is configured to control the carrier unit to carry the photovoltaic module to the above devices and platform according to the sequence of the steps in the method for testing mechanical tolerance of the photovoltaic module according to any one of claims 1-5.

9. The system according to claim 8, further comprising: an infrared imaging device configured to perform an internal structure inspection on the photovoltaic module.

10. The system according to claim 8 or 9, wherein the light attenuation rate test device comprises a light absorption test chamber.
